# EUROPEAN PATENT APPLICATION

(11) **EP 4 618 149 A2**
(43) Date of publication of application: **17.09.2025**
(21) Application number: 25160548.1
(22) Date of filing: 27.02.2025
(51) Int. Cl.: H01L 23/538, H01L 23/00

(54) **HYBRID RECONSTITUTED PANEL LEVEL PACKAGE**

(30) Priority: 13.03.2024 US 202463564830 P; 24.06.2024 US 202418752237
(71) Applicant: Samsung Electronics Co., Ltd., Suwon-si, Gyeonggi-do 16677 (KR)
(72) Inventor: YANG, Jin, San Jose, CA, 95134 (US); KIM, WooPoung, San Jose, CA, 95134 (US)
(74) Representative: Kuhnen & Wacker Patent- und Rechtsanwaltsbüro PartG mbB

(57) **Abstract**

A semiconductor device and a method of manufacturing the semiconductor device are provided. The method of manufacturing the semiconductor device may include forming semiconductor sub-packages by performing a fan-out wafer level packaging process; singulating the semiconductor sub-packages from at least one wafer; and reconstituting the semiconductor sub-packages into a fan-out panel level package (FOPLP).

## Description

### BACKGROUND

### 1. Field

Embodiments of the present disclosure relate to a semiconductor package and a method of manufacturing thereof, and, more particularly, a hybrid reconstituted panel level package and a method of manufacturing thereof.

### 2. Description of Related Art

In order to meet increasing demand of high performance computing and artificial intelligence (AI), core counts of modem processing units (PUs), such as central processing units (CPUs), graphics processing units (GPUs), accelerated processing units (APUs), etc., have been increasing to combat the slowdown of the end of Moore's Law. This is resulting in chip sizes that are increasingly difficult to arrange for efficient production on current wafer sizes.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

However, due to the increasing core count, comparative embodiments have a "memory wall" problem.

Additionally, there is a need to develop a larger form factor package/chip architecture that integrates logic dies and memory dies.

There is also a need of a solution to address increasing challenges of package warpage for large form-factor packages.

Embodiments of the present disclosure may address the above problems and/or other problems.

According to some example embodiments of the present disclosure, a hybrid reconstituted panel level package and a method of manufacturing thereof may be provided.

According to some example embodiments of the present disclosure, the hybrid reconstituted panel level package may have a hybrid package architecture, and may be a large form factor package (e.g., greater than 80 mm by 80 mm, such as 200 mm by 200 mm or even a panel size of 600 mm by 600 mm), may have fine redistribution layer (RDL) line/space (L/S), and/or may have a high RDL layer count.

According to some example embodiments of the present disclosure, a method of manufacturing a semiconductor device may be provided and include: forming semiconductor sub-packages by performing a fan-out wafer level packaging process; singulating the semiconductor sub-packages from at least one wafer; and reconstituting the semiconductor sub-packages into a fan-out panel level package (FOPLP).

According to some example embodiments of the present disclosure, a FOPLP may be provided and include semiconductor sub-packages that are fan-out wafer level packages (FOWLPs). The semiconductor sub-packages may include a first sub-package including: redistribution layers; a first bridge on the redistribution layers of the first sub-package; and a semiconductor chip above the first bridge of the first sub-package, the semiconductor chip of the first sub-package electrically connected to the first bridge of the first sub-package. The semiconductor sub-packages may further include a second sub-package including: redistribution layers; a first bridge on the redistribution layers of the second sub-package; and a semiconductor chip above the first bridge of the second sub-package, the semiconductor chip of the second sub-package electrically connected to the first bridge of the second sub-package, wherein in the FOPLP, the semiconductor sub-packages are arranged adjacent to each other in at least one horizontal direction of the FOPLP.

According to some example embodiments of the present disclosure, a fan-out panel level package (FOPLP) may be provided and include semiconductor sub-packages including a first sub-package including: redistribution layers; a first mold layer on the redistribution layers; first semiconductor chips on the first mold layer; and a second semiconductor chip, different from the first semiconductor chips, on the first mold layer. The semiconductor sub-packages may further include a second sub-package. The first mold layer may include: a first bridge that electrically connects one of the first semiconductor chips to a semiconductor chip of the second sub-package, wherein, in the FOPLP, the semiconductor sub-packages are arranged adjacent to each other in at least one horizontal direction of the FOPLP.

### BRIEF DESCRIPTION OF DRAWINGS

Example embodiments of the present disclosure will be more clearly understood from the following detailed description taken in conjunction with the accompanying drawings in which:
FIG. 1A illustrates a schematic diagram for explaining predicted yield of semiconductor chips in a fan-out wafer level packaging process;
FIG. 1B illustrates a schematic diagram for explaining predicted yield of semiconductor chips in a fan-out wafer level packaging process;
FIG. 1C illustrates a schematic diagram for explaining predicted yield of semiconductor chips in a fan-out wafer level packaging process;
FIG. 1D illustrates a schematic diagram for explaining predicted yield of semiconductor chips in a fan-out wafer level packaging process;
FIG. 2 illustrates a schematic diagram of a semiconductor package according to some example embodiments of the present disclosure;
FIG. 3 illustrates a schematic diagram of a semiconductor package according to some example embodiments of the present disclosure;
FIG. 4 illustrates a schematic diagram of a sub-package of a semiconductor package according to some example embodiments of the present disclosure;
FIG. 5 illustrates a schematic diagram of a sub-package of a semiconductor package according to some example embodiments of the present disclosure;
FIG. 6 illustrates a schematic cross-sectional view of a semiconductor package according to some example embodiments of the present disclosure;
FIG. 7 illustrates a schematic cross-sectional view of a portion of the semiconductor package shown in FIG. 6;
FIG. 8A illustrates a flowchart for a method of manufacturing a semiconductor package according to some example embodiments of the present disclosure;
FIG. 8B illustrates a flowchart for a method of manufacturing a semiconductor package according to some example embodiments of the present disclosure;
FIG. 9 illustrates a sub-package formed in an operation of the methods of FIGS. 8A-B;
FIG. 10 illustrates a sub-package formed in an operation of the methods of FIGS. 8A-B;
FIG. 11 illustrates a sub-package formed in an operation of the methods of FIGS. 8A-B;
FIG. 12 illustrates a sub-package formed in an operation of the methods of FIGS. 8A-B;
FIG. 13 illustrates a sub-package formed in an operation of the methods of FIGS. 8A-B;
FIG. 14 illustrates a sub-package formed in an operation of the methods of FIGS. 8A-B;
FIG. 15 illustrates a sub-package formed in an operation of the methods of FIGS. 8A-B;
FIG. 16 illustrates a sub-package formed in an operation of the methods of FIGS. 8A-B;
FIG. 17 illustrates a sub-package formed in an operation of the methods of FIGS. 8A-B;
FIG. 18 illustrates a sub-package formed in an operation of the methods of FIGS. 8A-B;
FIG. 19 illustrates a sub-package formed in an operation of the methods of FIGS. 8A-B;
FIG. 20 illustrates a sub-package formed in an operation of the methods of FIGS. 8A-B;
FIG. 21 illustrates a sub-package formed in an operation of the methods of FIGS. 8A-B;
FIG. 22 illustrates a sub-package formed in an operation of the methods of FIGS. 8A-B;
FIG. 23 illustrates a sub-package formed in an operation of the methods of FIGS. 8A-B;
FIG. 24 illustrates a sub-package formed in an operation of the methods of FIGS. 8A-B;
FIG. 25 illustrates a sub-package formed in an operation of the methods of FIGS. 8A-B; and
FIG. 26 illustrates a semiconductor package formed in an operation of the methods of FIGS. 8A-B.

### DETAILED DESCRIPTION

Embodiments of the present disclosure described herein are example embodiments, and thus, the present disclosure is not limited thereto, and may be realized in various other forms. Each of the embodiments provided in the following description is not excluded from being associated with one or more features of another embodiment also provided herein or not provided herein but consistent with the present disclosure. For example, even if matters described in a specific example embodiment are not described in a different example embodiment, the matters may be understood as being related to or combined with the different example embodiment, unless otherwise mentioned in descriptions thereof. In addition, it should be understood that all descriptions of principles, aspects, examples, and embodiments of the present disclosure are intended to encompass structural and functional equivalents thereof. In addition, these equivalents should be understood as including not only currently well-known equivalents but also equivalents to be developed in the future, that is, all devices that perform the same functions regardless of the structures thereof.

It will be understood that when an element, component, layer, pattern, structure, region, or so on (hereinafter collectively "element") of a semiconductor device (or semiconductor package) is referred to as being "on," "connected to," or "coupled to" another element the semiconductor device, it can be directly on, connected to, or coupled to the other element or an intervening element(s) may be present. In contrast, when an element of a semiconductor device is referred to as being "directly on," "directly connected to," or "directly coupled to" another element of the semiconductor device, there are no intervening elements present. Like numerals refer to like elements throughout the present disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element to distinguish the two elements.

It will be understood that, although the terms "first," "second," "third," "fourth," "fifth," "sixth," etc. may be used herein to describe various elements, these elements should not be limited by these terms. These terms are only used to distinguish one element from another element. Thus, a first element discussed below could be termed a second element without departing from the scope of the present disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being performed later than another step or operation may be performed prior to or at the same time as the other step or operation unless the other step or operation is described as necessarily being performed prior to the step or operation. Further, the method may include additional steps or operations not mentioned in the description.

Many example embodiments are described herein with reference to cross-sectional views that are schematic illustrations of the embodiments (and intermediate structures). As such, variations from the shapes of the illustrations as a result of, for example, manufacturing techniques and/or tolerances are to be expected. Thus, the embodiments should not be construed as limited to the particular shapes of regions illustrated herein, and are to include deviations in shapes that result from, for example, manufacturing. Various regions illustrated in the figures are schematic in nature and their shapes may not be intended to illustrate the actual shape of a region of a device and are not intended to limit the scope of the present disclosure. Further, in the drawings, the sizes and relative sizes of layers and regions may be exaggerated for clarity.

For the sake of brevity, conventional elements, structures, or layers included in a semiconductor package including a connection pad, an adhesive layer, an isolation layer, a barrier metal pattern, a seed layer, etc. may or may not be described in detail herein. For example, descriptions of certain connection pads of a semiconductor chip connected to solder balls or bumps in a semiconductor package may be omitted herein when these structural elements are not related to certain features of the embodiments. Also, descriptions of materials forming well-known structural elements may be omitted herein when those materials are not relevant to certain features of the embodiments. Herein, the term "connection" between two structures or elements may refer to a electrical connection therebetween. For example, a connection between semiconductor chips, semiconductor packages, and/or semiconductor devices may refer to an electrical connection of a corresponding two or more elements to each other. The terms "coupled" and "connected" may have the same meaning and may be used interchangeably herein. Further, the term "isolation" between two structures or elements pertains to electrical insulation or separation therebetween. For example, isolation of wiring patterns from each other may mean that the wiring patterns are not electrically connected to each other.

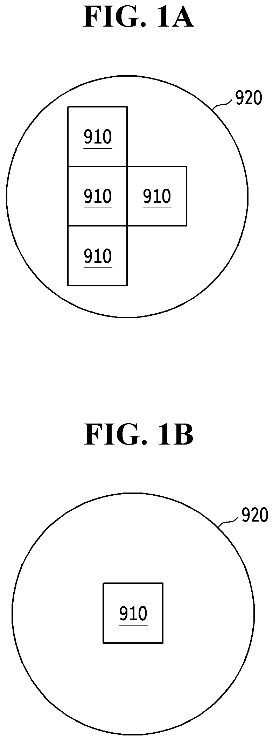

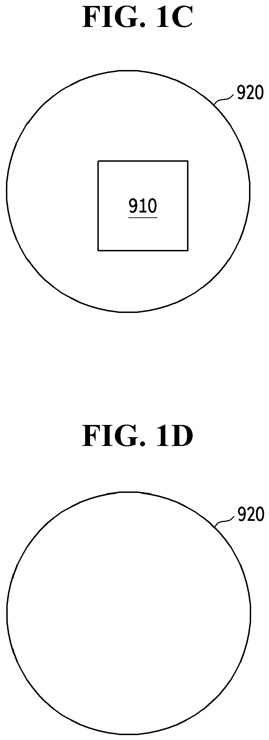

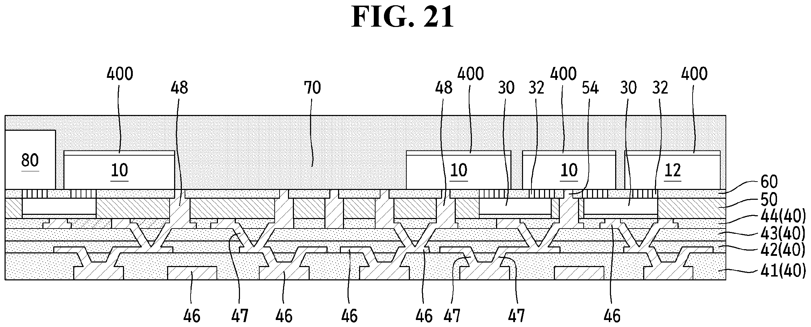

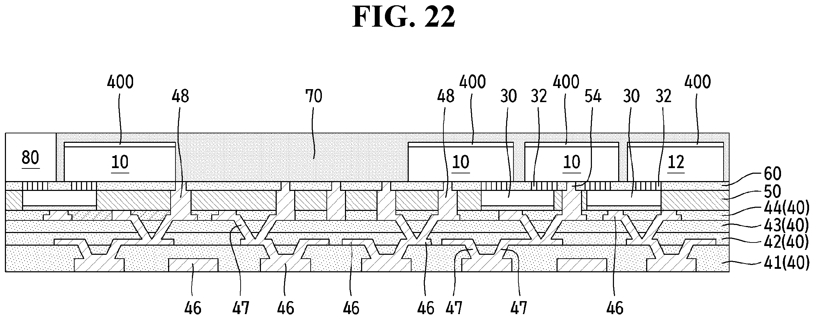

Hereinafter, various example embodiments of the present disclosure are described with reference to FIGS. 1-26.

In order to meet increasing demand of high performance computing and Ai, core counts of modern Pus, such as CPUs, GPUs, APUs, etc., have been increasing to combat the slowdown of the end of Moore's Law. For example, the core count for modem CPUs has recently exceeded 64 cores (66 printed cores). Further to meet the needs of modem AI and gaming usage, today's GPU chips have over thousands of GPU cores. However, with increasing CPU/GPU core count, a new problem of a "memory wall" has become a bottleneck. The memory wall describes implications of the processor/memory performance gap that has grown steadily over the last several decades. If memory latency and bandwidth become insufficient to provide processors with enough instructions and data to continue computation, processors will increasingly be stalled waiting on memory. The trend of placing more and more cores on chips exacerbates the situation, since each core may enjoy a relatively narrower channel to shared memory resources. In today's compute architecture, processors fetch data from a hierarchy of memory, from fast but low capacity L1 cache, to L2 cache, to L3 cache, and then to relatively slower but high capacity dynamic random access memory ("DRAM"). In order to bridge this gap, high bandwidth memory (HBM) has been introduced and integrated directly with computing engines using advanced packaging, including 2.5D and 3D integrated circuit (IC) packages. By placing an HBM closer to processor cores, it helps reduce latency and increase storage capacity at the same time. However, there is still a latency when transferring a large amount of data between the processor cores and HBM through a silicon interposer or active silicon. Meanwhile, standard HBMs which follow JEDEC standard, have had increasing power. For example, HBM3 power is trending to 30 W at 6.4 Gbps for 12H 24GB HBM3.

Silicon interposer based 2.5D packages may be used in GPU, AI, and network chips with a large form factor. It is projected that silicon interposer based 2.5D packages would reach the limit constrained by manufacturing efficiency, and technical challenges including increasing warpage and mechanical integrity. Embedded silicon bridge based fan-out interposers (either fan-out or panel-level) are also proposed for going beyond this limit.

With increasing package form factor, package warpage risk may increase. Therefore, there is a need of a solution to address increasing challenges of package warpage for large form-factor packages.

Additionally, due to the AI revolution, there is a need to develop a larger form factor (FF) package/chip architecture that integrates logic dies and memory dies (e.g., DRAM), with more memory being as close as possible to the logic dies for increased memory bandwidth and capacity. Such a need is particularly relevant to high performance computing (HPC) and data centers.

HBMs may be integrated with logic chips into one package to provide desired memory bandwidth and capacity in observance of memory wall challenges. This type of integration may be implemented via 2.5D IC packages using a silicon interposer. For example, a package may include one lane of HBM chips (e.g., HBM2, HBM3, HBM4) on each side of logic chips (e.g., GPU or other application-specific integrated circuit (ASIC)). For example, a package may include six HBM3 on a chip with three HBM3 on each side of one central GPU. This chip may be implemented using a 2.5D package that includes a silicon interposer.

Silicon bridges may be embedded into a fan-out wafer level package (FOWLP) and a fan-out panel level packaging (FOPLP), in which over-molding is used to build a panel-level interposer. The embedded silicon bridges may be used to provide fine electrical routing among system on chips (SoCs), HBMs, and other ASICs, since this type of embedded silicon bridges may be fabricated using a back end of line (BEOL) fabrication process.

Fan out packages with fine line/space are normally fabricated via fan-out wafer level packaging by using a fine-feature stepper that has a limited lithography window size (e.g., a 2x reticle size). Fan-out wafer level packaging may include finer feature sizes, such as finer RDL line/space (L/S), and a higher RDL layer count. L/S may refer to a width and pitch of a metal trace. However, fan-out wafer level packaging of comparative embodiments may have a problem of including a small form factor, limited by a 12 in. wafer size (300 mm in diameter).

For example, in a fan-out wafer level packaging process, with reference to FIGS. 1A-D, a maximum size of semiconductor chips 910 (also referred to as semiconductor chip dies, silicon chips, or molded chips) that may be economically fabricated from a wafer 920 is very limited. FIGS. 1A-D illustrate schematic diagrams for explaining predicted yields of semiconductor chips in a fan-out wafer level packaging process.

With reference to FIG. 1A, in a case that the semiconductor chips 910 are to be 80 mm (width) by 80 mm (height), four semiconductor chips 910 are able to be economically fabricated (i.e., with minimal process defects) from the wafer 920, in a case where the wafer 920 has a diameter of 300 mm. With reference to FIG. 1B, in a case that the semiconductor chips 910 are to be 100 mm (width) by 100 mm (height), one semiconductor chip 910 is able to be economically fabricated from the wafer 920, in a case where the wafer 920 has a diameter of 300 mm. With reference to FIG. 1B, in a case that the semiconductor chips 910 are to be 120 mm (width) by 120 mm (height), one semiconductor chip 910 is able to be economically fabricated from the wafer 920, in a case where the wafer 920 has a diameter of 300 mm. With reference to FIG. 1D, in a case that the semiconductor chips 910 are to be 150 mm (width) by 150 mm (height), no semiconductor chips 910 are able to be economically fabricated from the wafer 920, in a case where the wafer 920 has a diameter of 300 mm. Thus, a maximum size of the semiconductor chips 910 that may be economically fabricated from the wafer 920 (in a case where the wafer 920 has a diameter of 300 mm), in a fan-out wafer level packaging process, may be 120 mm (width) by 120 mm (height). Additionally, in view of this fabrication constraint, a semiconductor chip 910 (or a molded package) having a size of 150 mm (width) by 150 mm (height) may not be directly fabricated using a fan-out wafer level packaging process.

While it may be technically possible to fabricate more than four semiconductor chips 910 from the wafer 920 in a case where the wafer 920 has a diameter of 300 mm, at least some of the semiconductor chips 910 in such an arrangement may be too close to an edge of the wafer 920, which is likely to cause the at least some of the semiconductor chips 910 to be defective. That is, at the edges of a wafer (e.g., the wafer 920), process errors are very high, thereby likely causing defects in semiconductor chips 910 placed at the edges of the wafer. Thus, it is generally not economical to fabricate more than four semiconductor chips 910 that have dimensions of 80 mm (width) by 80 mm (height), or more than one semiconductor chip 910 that has dimensions of 100 mm (width) by 100 mm (height) or dimensions of 120 mm (width) by 120 mm (height), from one wafer 920 that has a diameter of 300 mm.

Another type of fan-out packaging is fan-out panel level packaging. Fan-out panel-level packaging may have advantages of including a larger package form factor, and disadvantages of larger RDL L/S and lower RDL layer count, as compared to fan-out wafer level packaging.

In comparative embodiments, a large form factor package with fine features and a large number of RDL layers may not be realized by fan-out panel level packaging, itself, since panel level packaging in comparative embodiments include course wire L/S and a low RDL count (e.g., 1 RDL layer). For example, in forming large form factor packages of comparative embodiments, it may be difficult to control manufacturing tolerances due to the larger sizes.

According to some example embodiments of the present disclosure, a large form factor panel level package (e.g., a fan-out panel level package (FOPLP)) may be provided with a hybrid package architecture. For example, the large form factor panel level package may be formed by reconstituting and integrating multiple fan-out packages (also referred to as sub-packages, interposer-lets, or sub-interposers) that are singulated. For example, the sub-packages, that are to be reconstituted into the one large form factor panel level package (or FOPLP), can have fine features including, but not limited to, fine line/space (L/S) and multiple redistribution (RDL) layers. For example, the sub-packages may have a line width (or L/S) of 1-2 µm and may include 6 RDL layers. For example, the sub-packages may each be a fan-out wafer level package (FOWLP) that is manufactured in a fan-out wafer level packaging process, or may each be a FOPLP that is manufactured in a fan-out panel level packaging process.

According to some example embodiments of the present disclosure, by integrating multiple fan out packages, as sub-packages (or interposer-lets or sub-interposers), into one panel level package (e.g., an FOPLP) through reconstitution, an expanded form factor may be obtained. For example, the one panel level package (e.g., an FOPLP) may be a large form factor package with fine features and a large number of RDL layers for routing and/or meeting signal integrity/power integrity (SI/PI) requirements through this constitution.

According to some example embodiments of the present disclosure, a method of manufacturing the semiconductor package having the hybrid package architecture may be provided.

According to some example embodiments of the present disclosure, a semiconductor package (e.g., an FOPLP) having the hybrid package architecture may be provided that integrates advantages of fan-out wafer level packaging and fan-out panel level packaging, while also avoiding disadvantages of fan-out wafer level packaging and fan-out panel level packaging. Such advantages of fan-out wafer level packaging may include finer feature sizes, such as finer RDL L/S, and a higher RDL layer count, and such disadvantages of fan-out wafer level packaging that may be avoided include a smaller form factor (as compared to fan-out panel level packaging). Such advantages of fan-out panel level packaging may include larger package form factor, and such disadvantages of panel-level packaging that may be avoided include course RDL L/S and lower RDL layer count (as compared to fan-out wafer level packaging).

According to some example embodiments of the present disclosure, a semiconductor package (e.g., an FOPLP) having the hybrid package architecture, that may be manufactured by the method, may be a large form factor package (e.g., greater than 80 mm by 80 mm, such as 150mm by 150mm, 200 mm by 200 mm, 300 mm by 300 mm, or even a full panel size of 600 mm by 600 mm) and may have fine RDL L/S and a high RDL layer count. For example, the semiconductor package may be a large form factor package that integrates an increased amount of ASICs and memory into a single package with fine features and a large number of RDL layers for routing and/or meeting signal SI/PI requirements.

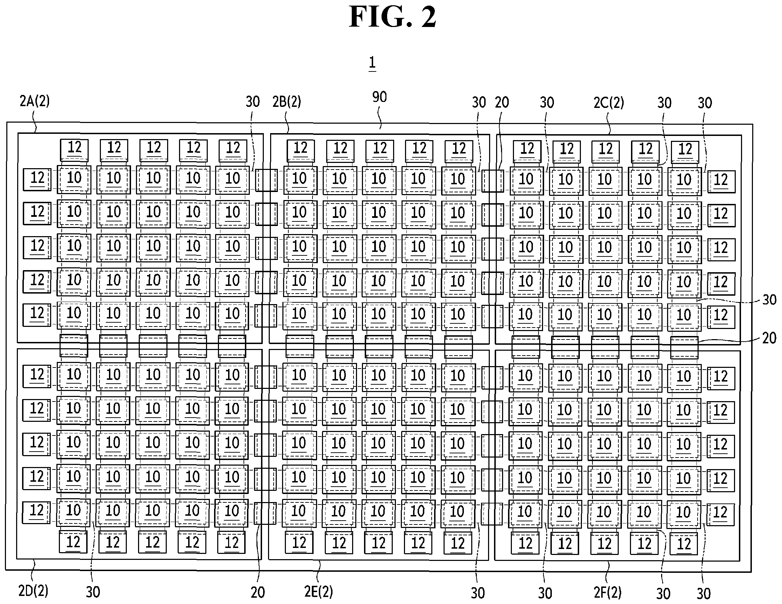

With reference to FIGS. 2-8, a semiconductor package 1 according to some example embodiments of the present disclosure is described below. The semiconductor package 1 is an example of the semiconductor package (e.g., the FOPLP) having the hybrid package architecture, and that may be a large form factor package, have a fine RDL L/S, and have a high RDL layer count.

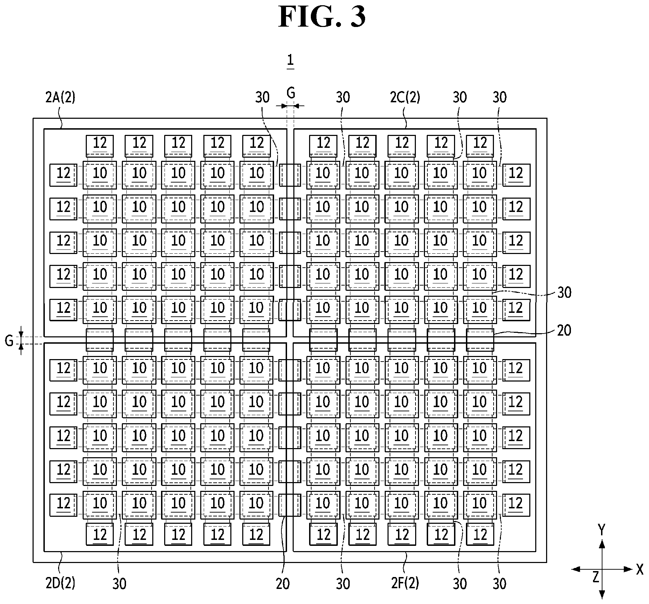

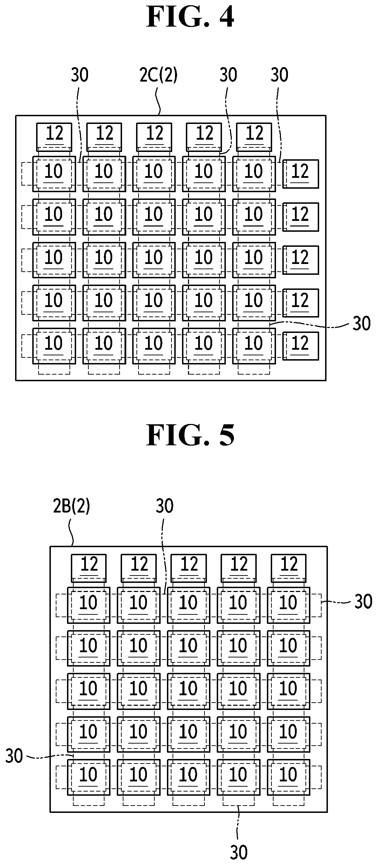

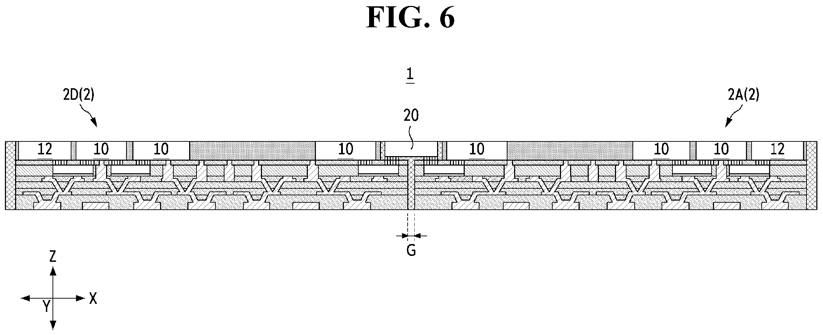

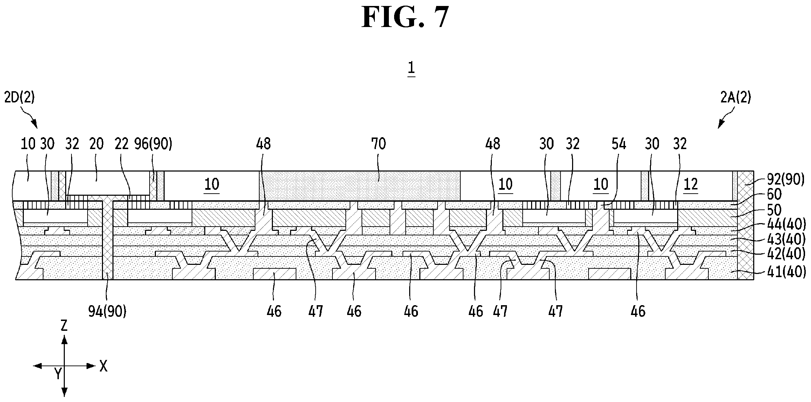

FIG. 2 illustrates a schematic diagram of the semiconductor package 1 according to some example embodiments of the present disclosure. FIG. 2 illustrates a schematic diagram of the semiconductor package 1, having a first configuration, according to some example embodiments of the present disclosure. FIG. 3 illustrates a schematic diagram of the semiconductor package 1, having a second configuration, according to some example embodiments of the present disclosure. FIG. 4 illustrates a schematic diagram of a sub-package 2 of the semiconductor package 1 according to some example embodiments of the present disclosure. FIG. 5 illustrates a schematic diagram of a sub-package 2 of the semiconductor package 1 according to some example embodiments of the present disclosure. FIG. 6 illustrates a schematic cross-sectional view of the semiconductor package 1 according to some example embodiments of the present disclosure. FIG. 7 illustrates a schematic cross-sectional view of a portion of the semiconductor package 1 shown in FIG. 6.

The semiconductor package 1 may be a hybrid reconstituted panel level package that is manufactured using a hybrid reconstituted panel level packaging process according to some example embodiments of the present disclosure. For example, the semiconductor package 1 may be a FOPLP that includes sub-packages 2. The sub-packages 2 may be singulated from a package (e.g., a FOWLP or a FOPLP) and reconstituted into the semiconductor package 1 using a fan-out panel level packaging process of the hybrid reconstituted panel level packaging process, as described further herein. In a case where the sub-packages 2 are singulated from a FOWLP, such FOWLP (and its sub-packages 2) may be manufactured by a fan-out wafer level packaging process of the hybrid reconstituted panel level packaging process. In a case where the sub-packages 2 are singulated from a FOPLP, such FOPLP (and its sub-packages 2) may be manufactured by an additional fan-out panel level packaging process of the hybrid reconstituted panel level packaging process. According to some example embodiments, the additional fan-out panel level packaging process for manufacturing the sub-packages 2 may be the same or substantially similar to the fan-out panel level packaging process for reconstituting the sub-packages 2 into the semiconductor package 1, such that the fan-out panel level packaging process is performed iteratively to form the sub-packages 2 and then the semiconductor package 1. According to some example embodiments, the additional fan-out panel level packaging process for manufacturing the sub-packages 2 may be different from the fan-out panel level packaging process for reconstituting the sub-packages 2 into the semiconductor package 1.

As shown in FIG. 2, the semiconductor package 1 may include any number (N) greater than 1 of sub-packages 2. In the illustrated example, six sub-packages 2 (N = 6) are shown. For example, the semiconductor package 1 may include a sub-package 2A, a sub-package 2B, a sub-package 2C, a sub-package 2D, a sub-package 2E, and a sub-package 2F, wherein the sub-package 2A, the sub-package 2C, the sub-package 2D, and the sub-package 2F may be corner sub-packages that may define respective corners of the semiconductor package 1 and have a first shape, while the sub-package 2B and the sub-package 2E may be inner sub-packages that further define portions of the semiconductor package 1 between the corners and have a second shape that may be different from the first shape. For example, in the plan view, the sub-package 2A may be an upper-left corner of the semiconductor package 1, the sub-package 2B may be adjacent to a right side of the sub-package 2A, the sub-package 2C may be adjacent to a right side of the sub-package 2B and may define an upper-right corner of the semiconductor package 1, the sub-package 2D may be adjacent to a lower side of the sub-package 2A and define a lower-left corner of the semiconductor package 1, the sub-package 2E may be adjacent to a right side of the sub-package 2D, and the sub-package 2F may be adjacent to a right side of the sub-package 2E and may define a lower-right corner of the semiconductor package 1. However, embodiments of the present disclosure are not limited thereto. For example, an arrangement and number of sub-packages 2 in the semiconductor package 1 may be varied. For example, as shown in FIG. 3, the semiconductor package 1 may include only four sub-packages 2, that are corner sub-packages, by including the sub-package 2A, the sub-package 2C, the sub-package 2D, and the sub-package 2F, and omitting the sub-package 2B and the sub-package 2E. In further example embodiments of the present disclosure, the package 1 may have sub-packages 2 not comprising an edge of the package 1 such as, for example, a package 1 having nine sub-packages 2 may have four corner sub-packages 2, four edge sub-packages 2, and a central sub-package 2. According to some example embodiments, the semiconductor package 1, the sub-packages 2, and an arrangement of the sub-packages 2 within the semiconductor package 1, may each have a rectangular shape. In other possible embodiments, the sub-packages 2 may have other shapes, such as triangles, hexagons, irregular shapes, or the like, depending on the desired final shape of the package 1.

With reference to FIGS. 2-7, each of the sub-packages 2 may include first semiconductor chips 10, second semiconductor chips 12, and first bridges 30.

The first semiconductor chips 10 may be, for example, SoCs or ASICs. According to some example embodiments, the first semiconductor chips 10 may be arranged in an array pattern. For example, the array pattern may be a five (rows) by five (columns) array pattern, but embodiments of the present disclosure are not limited thereto. For example, the first semiconductor chips 10 may be arranged in any configuration. According to some example embodiments, the first semiconductor chips 10 may be the same or different types of chips from each other including, but not limited to, SoCs, ASICS, fabric chips, input/output (I/O) chips, HBMs, SerDes chips, etc., and the chips may have the same or different sizes from each other.

The second semiconductor chips 12 may be, for example, memory (e.g., HBMs). According to some example embodiments, the second semiconductor chips 12 may be arranged at and along at least one side of each of the sub-packages 2 that defines an outer side of the semiconductor package 1. For example, each of the corner sub-packages (e.g., the sub-package 2A, the sub-package 2C, the sub-package 2D, and the sub-package 2F) may include at least one row (or column) of the second semiconductor chips 12 at and along a first side of the corner sub-package that defines a first outer side of the semiconductor package 1 and at least one column (or row) of the second semiconductor chips 12 at and along a second side of the corner sub-package that defines a second outer side of the semiconductor package 1. Also, the inner sub-packages (e.g., the sub-package 2B and the sub-package 2E) may include at least one row (or column) of the second semiconductor chips 12 at and along a side of the inner sub-package that defines an outer side of the semiconductor package 1. However, an arrangement of the second semiconductor chips 12 according to example embodiments of the present disclosure is not limited. For example, the second semiconductor chips 12 may be arranged in any configuration. According to some example embodiments, the second semiconductor chips 12 may be the same or different types of chips from each other including, but not limited to, SoCs, ASICS, fabric chips, I/O chips, HBMs, SerDes chips, etc., and the chips may have the same or different sizes from each other.

Additionally, an arrangement of the first semiconductor chips 10 and the second semiconductor chips 12 with respect to each other is not limited. For example, one or more of the first semiconductor chips 10 (or the second semiconductor chips 12) may be stacked on one or more of the second semiconductor chips 12 (or the first semiconductor chips 10).

The first bridges 30 may be, for example, embedded bridges and may include silicon (Si). According to some example embodiments, the plurality of first bridges 30 may electrically connect the first semiconductor chips 10 to respective adjacent components such as, for example, an adjacent one of the first semiconductor chips 10, an adjacent one of the second semiconductor chips 12, and an adjacent one of second bridges 20 (described below). For example, in the plan view, four first bridges 30 may be provided at respective sides (e.g., a left side, an upper side, a right side, and a lower side in the plan view) of each of the first semiconductor chips 10, such as to electrically connect the first semiconductor chip 10 to a component (e.g., an adjacent one of the first semiconductor chips 10, an adjacent one of the second semiconductor chips 12, or an adjacent one of second bridges 20) adjacent to the first semiconductor chip 10 at the respective side.

The semiconductor package 1 may further include the second bridges 20. The second bridges 20 may be referred to as top connect bridges and may include, for example, silicon. The second bridges 20 may overlap pairs of adjacent ones of the sub-packages 2, that are separated by a gap G (see, e.g., FIGS. 3 and 6) to electrically connect the adjacent ones of the sub-packages 2. The gap G may extend between pairs of adjacent ones of the sub-packages 2 in a first horizontal direction (e.g., a direction X; see, e.g., FIGS. 3 and 6-7) and a second horizontal direction (e.g., a direction Y; see, e.g., FIGS. 3 and 6-7). According to some example embodiments, the second bridges 20 may overlap the gap G. According to some example embodiments, the first horizontal direction and the second horizontal direction may be non-parallel and non-perpendicular with respect to each other, or may be perpendicular with respect to each other.

In some embodiments, the second bridges 20 may overlap the pairs of adjacent ones of the sub-packages 2, that are separated by the gap G, and may each electrically connect together respective pairs of first bridges 30, closest to the gap G, of the pairs of adjacent sub-packages 2, thereby electrically connecting said adjacent sub-packages 2.

Accordingly, a pair of first semiconductor chips 10, which respectively belong to the pair of sub-packages 2 that are adjacent to each other (disregarding the first bridge chips 30), may be electrically connected together by a second bridge 20 that overlaps the pair of sub-packages 2, due to the second bridge 20 being electrically connected to the pair of first bridges 30.

The semiconductor package 1 may further include a molding material 90 that surrounds each of the sub-packages 2 and forms outer edges (e.g., a left edge, an upper edge, a right edge, and a lower edge in the plan view) of the semiconductor package 1. For example, portions of the molding material 90 may be in between and contact each pair of the sub-packages 2 that are adjacent to each other.

Referring to FIGS. 6-7, configurations of pairs of the sub-packages 2 that are adjacent to each other are described below. As an example, FIGS. 6-7 illustrate a schematic cross-sectional view of the sub-package 2D and the sub-package 2A, and the below description may refer to the sub-package 2D and the sub-package 2A. However, a person of ordinary in the art would have appreciated that the below description may be applied to each pair of the sub-packages 2 that are adjacent to each other. Additionally, FIGS. 6-7 may omit illustration of some components (e.g., some first semiconductor chips 10) for purposes of clarity.

With reference to FIGS. 6-7, each of the sub-packages 2 may include at least one lower RDL layer 40, a first mold layer 50, at least one upper RDL layer 60, a second mold layer 70, the first semiconductor chips 10, the second semiconductor chips 12, and the first bridges 30.

According to an example embodiment, the at least one lower RDL layer 40 may include four RDL layers. For example, the lower RDL layers 40 may include a first RDL layer 41, a second RDL layer 42, a third RDL layer 43, and a fourth RDL layer 44 that are stacked in a vertical direction (e.g., a direction Z; see, e.g., FIGS. 3 and 6-7), in that order. However, embodiments of the present disclosure are not limited thereto, and more or less than four RDL layers may be included in the at least one lower RDL layer 40. For example, the number of lower RDL layers 40 may be six or more (e.g., seven or more). According to some example embodiments, a line width (or L/S) of the RDL layers 40 may be 1-2 µm.

According to some example embodiments, each of the lower RDL layers 40 may include a dielectric layer that includes therein an interconnect structure for electrical connection between components. The interconnect structure may include, for example, interconnect patterns 46 and interconnect vias 47. The interconnect patterns 46 may extend in or one or more of the lower RDL layers 40 in a horizontal direction(s), and the interconnect vias 47 may extend in a vertical direction (e.g., the direction Z), through the dielectric layer of at least one of the lower RDL layers 40, such as to electrically connect together at least two of the interconnect patterns 46 and/or at least semiconductor devices (e.g., the first semiconductor chip 10, the second semiconductor chip 12, and/or another semiconductor chip inside or outside of the sub-package 2). The interconnect patterns 46 and the interconnect vias 47 may include materials comprising at least one from among: copper (Cu), copper alloy, aluminum (Al), and aluminum alloy, nickel (Ni), gold (Au), cobalt (Co), tantalum (Ta), tellurium (Te), titanium (Ti), tungsten (W) or alloys thereof (e.g., TiN, TaN), however, the metal material is not limited thereto. The dielectric layer may include at least one from among silicon oxide (SiO), silicon nitride (SiN), silicon oxynitride (SiON), silicon oxycarbide (SiOC), and silicon carbonitride (SiCN).

According to some example embodiments, interconnect patterns 46 of the first RDL layer 41 may be exposed from a lower surface of the dielectric layer of the first RDL layer 41 and may be electrically connected to components outside of the sub-package 2. For example, such interconnect pattern 46 may be pads for electrical connection. For example, the interconnect pattern 46 may be land grid array copper pads, and solder bumps may be formed underneath at least some of the pads. According to some example embodiments, spring-based electrical connections may provide electrical contacts between the interconnect pattern 46 and an outside of the sub-package 2.

According to some example embodiments, lower surfaces of interconnect patterns 46 of the first RDL layer 41, that are exposed, and a lower surface of the dielectric layer of the first RDL layer 41 may define a lower surface of the sub-package 2. According to some example embodiments, ball grid array (BGA) balls may be mounted on the lower surface of the sub-package 2 for electrical connection.

According to some example embodiments, the first mold layer 50 may be on an upper surface of the at least one lower RDL layer 40. In the first mold layer 50, posts 48 (e.g., copper posts) and the first bridges 30 may be provided. For example, the first mold layer 50 may surround and contact side surfaces of the posts 48 and the first bridges 30. The posts 48 may extend vertically from, and may be electrically connected to, interconnect patterns 46 of the RDL layer 40. The posts 48 may extend through the first mold layer 50 such as to be exposed at an upper surface of the first mold layer 50. The first bridges 30 may be electrically connected to interconnect patterns 46 the RDL layer 40.

According to some example embodiments, the upper RDL layer 60 may be on an upper surface of the first mold layer 50 and at least partially on an upper surface of the first bridges 30, and may electrically connect components (e.g., the posts 48 and/or the first bridges 30) in the first mold layer 50 to components (e.g., the first semiconductor chips 10 and/or the second semiconductor chips 12) above the upper RDL layer 60. For example, the upper RDL layer 60 may include a dielectric layer that includes an interconnect structure for electrical connection between the components. For example, the interconnect structure may include first pads 54 (or bumps) that electronically connect the posts 48 to the first semiconductor chips 10, and may further include second pads 32 (or bumps) that electrically connect the first bridges 30 to one or more from among the first semiconductor chips 10, the second semiconductor chips 12, and the second bridges 20. The interconnect structure may further include vias to form electrical connections with respect to the pads (e.g., the first pads 54 and/or the second pads 32). According to some example embodiments, the first pads 54 (or bumps) and the second pads 32 (or bumps) may include materials comprising at least one from among: copper (Cu), copper alloy, aluminum (Al), and aluminum alloy, nickel (Ni), gold (Au), cobalt (Co), tantalum (Ta), tellurium (Te), titanium (Ti), tungsten (W) or alloys thereof (e.g., TiN, TaN), however, the metal material is not limited thereto. The dielectric layer may include at least one from among silicon oxide (SiO), silicon nitride (SiN), silicon oxynitride (SiON), silicon oxycarbide (SiOC), and silicon carbonitride (SiCN). According to some example embodiments, the upper RDL layer 60 may be one or more RDL layers.

According to some example embodiments, the second mold layer 70 may be on an upper surface of the upper RDL layer 60. In the second mold layer 70, the first semiconductor chips 10 and the second semiconductor chips 12 may be provided. For example, the second mold layer 70 may surround and contact side surfaces of the first semiconductor chips 10 and the second semiconductor chips 12. Upper surfaces of the first semiconductor chips 10 and the second semiconductor chips 12 may be exposed from an upper surface of the second mold layer 70, and lower surfaces of the first semiconductor chips 10 and the second semiconductor chips 12 may be exposed from a lower surface of the second mold layer 70, at least at contact points with the upper RDL layer 60. According to some example embodiments, the upper surfaces of the first semiconductor chips 10, the upper surfaces of the second semiconductor chips 12, and the upper surface of the second mold layer 70 may define an upper surface of the sub-package 2.

As discussed above, the molding material 90 may surround each of the sub-packages 2 and forms outer sides (e.g., a left side, an upper side, a right side, and a lower side in the plan view) of the semiconductor package 1. For example, a first portion 92 of the molding material 90 may form the outer sides of the semiconductor package 1. The first portion 92 of the molding material 90 may be in contact with side surfaces of the lower RDL layers 40 (e.g., the dielectric layers thereof), the first mold layer 50, the upper RDL layer 60 (e.g., the dielectric layer thereof), and the second mold layer 70. A second portion 94 of the molding material 90 may be formed, within the gap G, between the pairs of the sub-packages 2 that are adjacent to each other. For example, the second portion 94 may be between the sub-package 2D and the sub-package 2A, within the gap G, and may contact side surfaces of the lower RDL layers 40 (e.g., the dielectric layers thereof), the first mold layer 50, and the upper RDL layer 60 (e.g., the dielectric layer thereof) of each of the sub-package 2D and the sub-package 2A. A third portion 96 of the molding material 90 may extend from an upper end of the second portion 94 of the molding material 90. For example, the third portion 96 of the molding material 90 may extend on upper surfaces of the upper RDL layers 60 and side surfaces of the second mold layer 70 of the pairs of the sub-packages 2 (e.g., the sub-package 2D and the sub-package 2A) that are adjacent to each other. The third portion 96 of the molding material 90 may surround and contact a bottom surface and side surfaces of the second bridges 20. For example, the second bridges 20 may be within the third portion 96 of the molding material 90, and upper surfaces of the second bridges 20 may be exposed from an upper surface of the third portion 96 of the molding material 90.

According to some example embodiments, third pads 22 (or bumps) may extend through the third portion 96 of the molding material 90 and may electrically connect at least some of the first bridges 30 (e.g., the first bridges 30 that are underneath the third portion 96 and/or adjacent to the second portion 94) to the second bridges 20 via the second pads 32 (or bumps). According to some example embodiments, the third pads 22 (or bumps) may include materials comprising at least one from among: copper (Cu), copper alloy, aluminum (Al), and aluminum alloy, nickel (Ni), gold (Au), cobalt (Co), tantalum (Ta), tellurium (Te), titanium (Ti), tungsten (W) or alloys thereof (e.g., TiN, TaN), however, the metal material is not limited thereto.. The dielectric layer may include at least one from among silicon oxide (SiO), silicon nitride (SiN), silicon oxynitride (SiON), silicon oxycarbide (SiOC), and silicon carbonitride (SiCN).

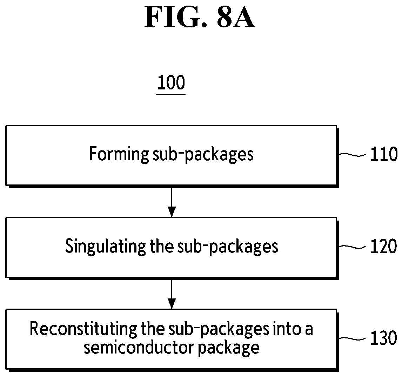

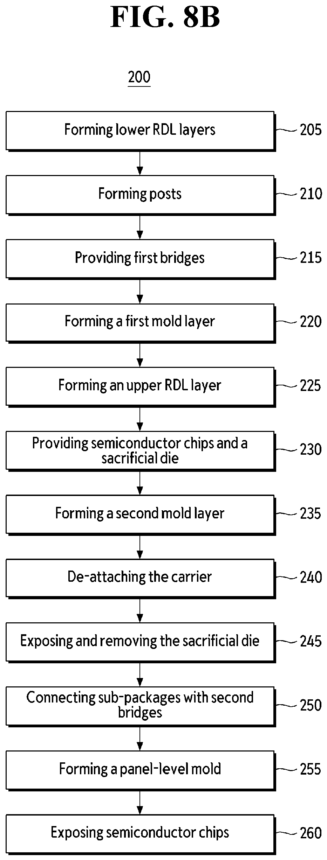

With reference to FIGS. 8-25 a manufacturing process of the semiconductor package 1 is described below.

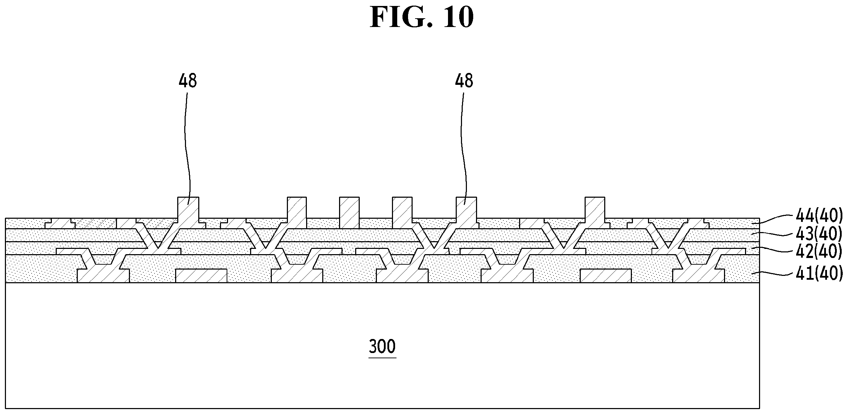

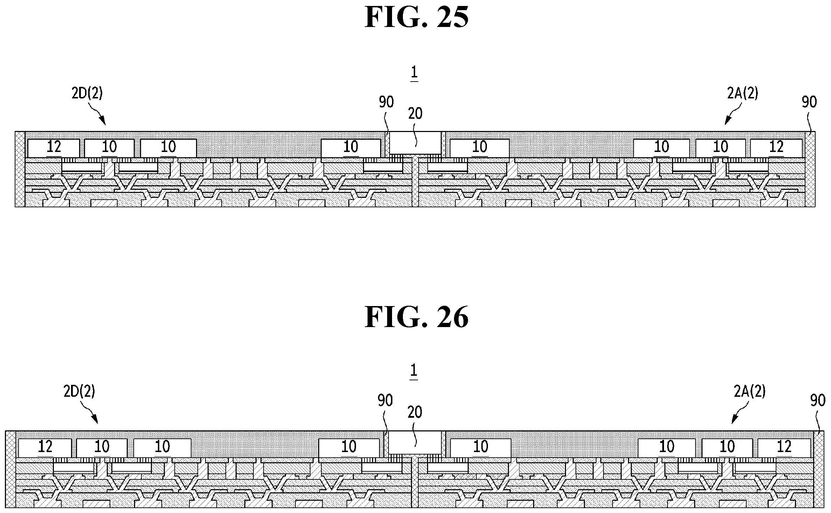

FIG. 8A illustrates a flowchart for a method 100 of manufacturing the semiconductor package 1 according to some example embodiments of the present disclosure. FIG. 8B illustrates a flowchart for a method 200 of manufacturing the semiconductor package 1 according to some example embodiments of the present disclosure. FIGS. 10-25 illustrate a sub-package formed in operations of the methods of FIGS. 8A-B. FIG. 26 illustrates the semiconductor package formed in an operation of the methods of FIGS. 8A-B.

With reference to FIG. 8A, the method 100 may include forming a plurality of sub-packages 2 (operation 110), singulating the sub-packages 2 (operation 120), and reconstituting the sub-packages 2 into a semiconductor package 1 (operation 130).

The operation 110 may include manufacturing FOWLPs, as the sub-packages 2, by performing a fan-out wafer level packaging process, or manufacturing FOPLPs, as the sub-packages 2, by performing a fan-out panel level packaging process. In a case where the sub-packages 2 are FOWLPs, the sub-packages 2 may have fine RDL features and a large RDL layer count by using a stepper with a small lithography window size in the fan-out wafer level packaging process. According to some example embodiments, any number of the sub-packages 2, that are later reconstituted into the semiconductor package 1, may be manufactured from a same wafer or different wafers. An example of the wafer(s) is wafer 920 of FIGS. 1A-D. According to some example embodiments, the wafer may have a circular shape in a plan view. According to some example embodiments, the operation 110 may include operations 205 to 245 of the method 200 of FIG. 8B as described below.

The operation 120 may include singulating the sub-packages 2 from the wafer from which they were manufactured. For example, in a case where a plurality of the sub-packages 2 are manufactured from a same wafer, the plurality of sub-packages 2 may be separated from each other by performing the singulation. Operation 120 may be performed at various times with respect to the method 200 of FIG. 8B as described below. For example, according to an example embodiment, the operation 120 may be performed after operation 245 and before operation 250 of the method 200 of FIG. 8B. According to an example embodiment, the operation 120 may be performed at various times before the operation 245.

The operation 130 may include reconstituting the sub-packages 2, after being singulated in the operation 120, into the semiconductor package 1. For example, the semiconductor package may be an FOPLP having the hybrid package architecture, and that may be a large form factor package, have a fine RDL L/S, and have a high RDL layer count. The operation 130 may include operation 250, operation 255, and operation 260 of the method 200 of FIG. 8B as described below. According to some example embodiments, the operation 130 may refer to performing a fan-out panel level packaging process.

With reference to FIG. 8B, the method 200 may include forming the lower RDL layers 40 (operation 205), forming the posts 48 (operation 210), providing the first bridges 30 (operation 215), forming the first mold layer 50 (operation 220), forming the upper RDL layer 60 (operation 225), providing semiconductor chips (e.g., first semiconductor chips 10 and the second semiconductor chips 12) and a sacrificial die 80 (operation 230); forming the second mold layer 70 (operation 235), de-attaching the carrier 300 (operation 240), exposing and removing the sacrificial die 80 (operation 245), connecting the sub-packages 2 with the second bridges 20 (operation 250), forming a panel-level mold (e.g., the molding material 90) (operation 255), and exposing the semiconductor chips (e.g., first semiconductor chips 10 and the second semiconductor chips 12) (operation 260).

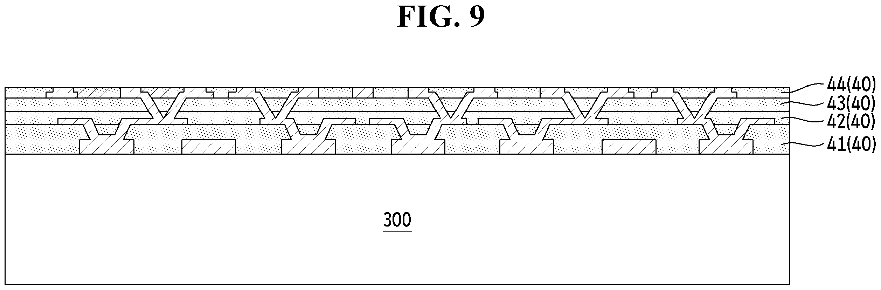

With reference to FIG. 9, the operation 205 may include forming the lower RDL layers 40 on an upper surface of a carrier 300. For example, the carrier 300 may be a substrate that is configured to support components thereon during a manufacturing process. The lower RDL layers 40 may include, for example, a first RDL layer 41, a second RDL layer 42, a third RDL layer 43, and a fourth RDL layer 44, but embodiments of the present disclosure are not limited thereto.

With reference to FIG. 10, the operation 210 may include forming the posts 48 on the upper surface of the lower RDL layers 40. For example, the posts 48 may be formed on the upper surface of the fourth RDL layer 44. For example, the posts 48 may be formed on interconnect patterns 46 (refer to FIG. 7) of the fourth RDL layer 44. According to some example embodiments, any number of the posts 48 may be provided.

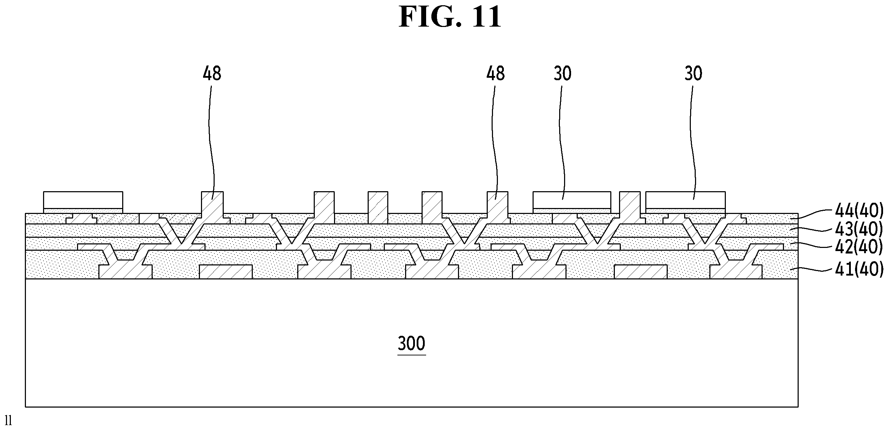

With reference to FIG. 11, the operation 215 may include providing the first bridges 30 on the upper surface of the lower RDL layers 40. For example, the first bridges 30 may be provided on the upper surface of the fourth RDL layer 44. For example, the first bridges 30 may be provided such as to be electrically connected to interconnect patterns 46 (refer to FIG. 7) of the fourth RDL layer 44. According to some example embodiments, any number of the first bridges 30 may be provided.

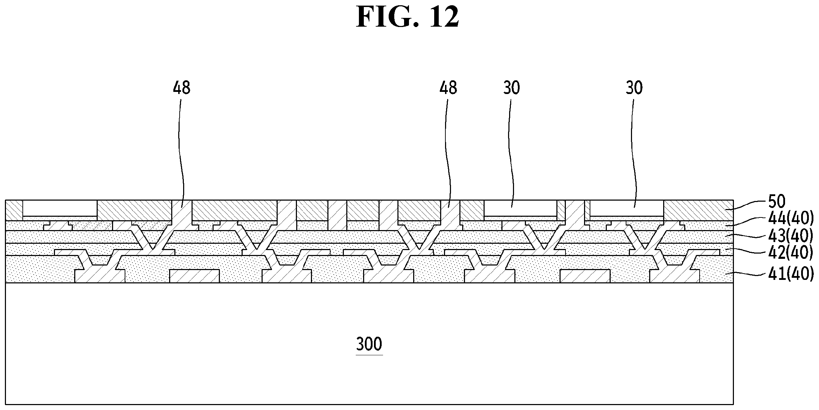

With reference to FIG. 12, the operation 220 may include forming the first mold layer 50 on the upper surface of the lower RDL layers 40. For example, the first mold layer 50 may be formed on the upper surface of the fourth RDL layer 44. For example, the first mold layer 50 may surround and contact side surfaces of the posts 48 and the first bridges 30.

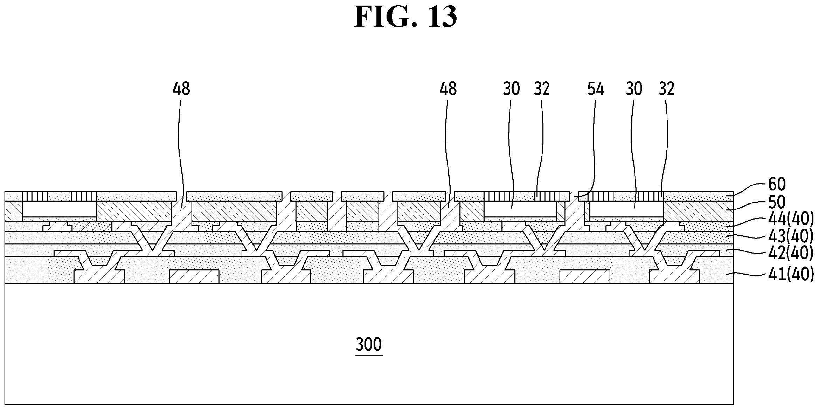

With reference to FIG. 13, the operation 225 may include forming the upper RDL layer 60 on the upper surface of the first mold layer 50. According to some example embodiments, the upper RDL layer 60 may include any number of RDL layers, and may further include any number of the first pads 54 (or bumps) and the second pads 32 (or bumps).

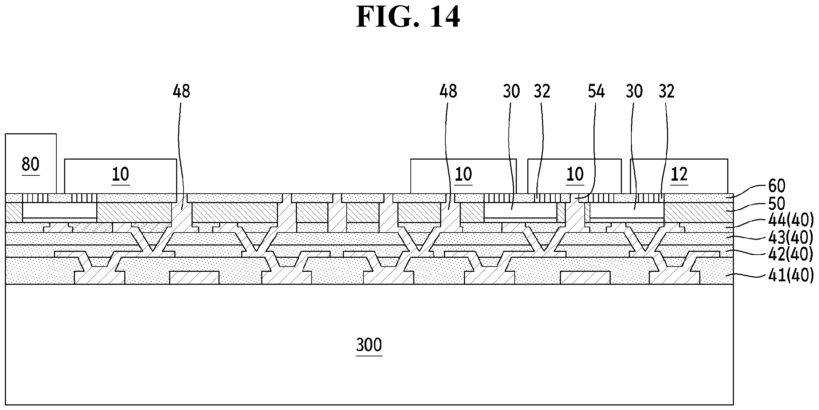

With reference to FIG. 14, the operation 230 may include providing the first semiconductor chips 10, the second semiconductor chips 12, and the sacrificial die 80 on the upper surface of the upper RDL layer 60. For example, the first semiconductor chips 10 may be provided such as to be electrically connected to the posts 48 via the first pads 54 (or bumps) and to at least some of the first bridges 30 via some of the second pads 32 (or bumps). For example, the second semiconductor chips 12 may be provided such as to be electrically connected to at least some of the first bridges 30 via some of the second pads 32 (or bumps). For example, the sacrificial die 80 may be provided at a lateral end of the sub-package 2 which may correspond to a side of a sub-package 2 that will be adjacent to another sub-package 2. According to some example embodiments, the sacrificial die 80 may have a thickness greater than a thickness of each of the first semiconductor chips 10 and the second semiconductor chips 12. For example, a level of an upper surface of the sacrificial die 80 may be higher than a level of upper surfaces of the first semiconductor chips 10 and the second semiconductor chips 12. According to some example embodiments, any number of the first semiconductor chips 10 and the second semiconductor chips 12 may be provided.

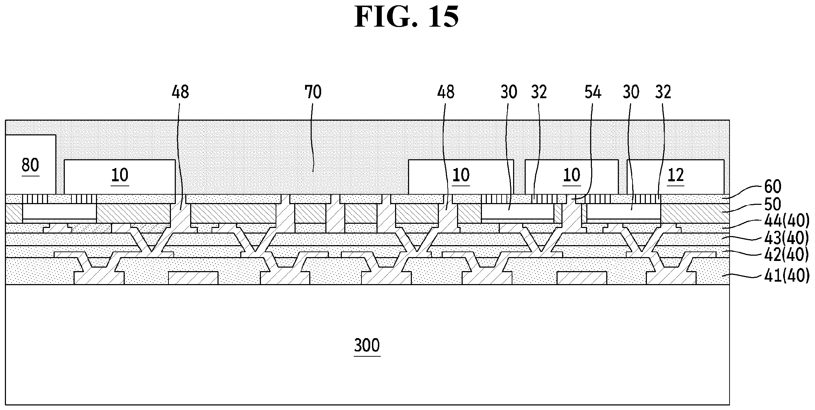

With reference to FIG. 15, the operation 235 may include forming the second mold layer 70 on the upper surface of the upper RDL layer 60. For example, the second mold layer 70 may surround and contact upper and side surfaces of the first semiconductor chips 10 and the second semiconductor chips 12, and may surround and contact an upper and an inner side surface of the sacrificial die 80.

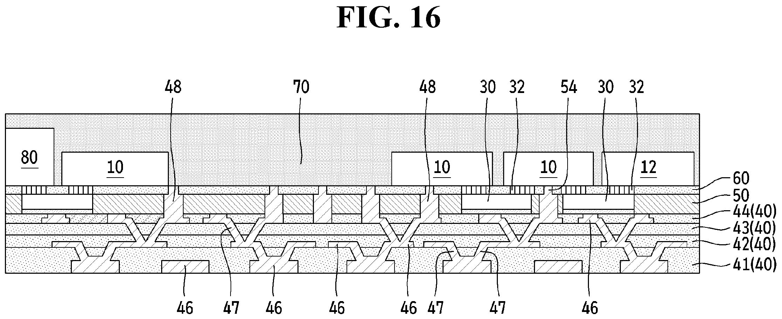

With reference to FIG. 16, the operation 240 may include de-attaching the carrier 300 from the lower RDL layers 40. For example, the carrier 300 may be de-attached from the first RDL layer 41. According to some example embodiments, the operation 240 may be performed after the operation 235 and before the operation 245, but embodiments of the present disclosure are not limited thereto. For example, the operation 240 may be performed after one or more from among the operation 245, the operation 250, the operation 255, and the operation 260.

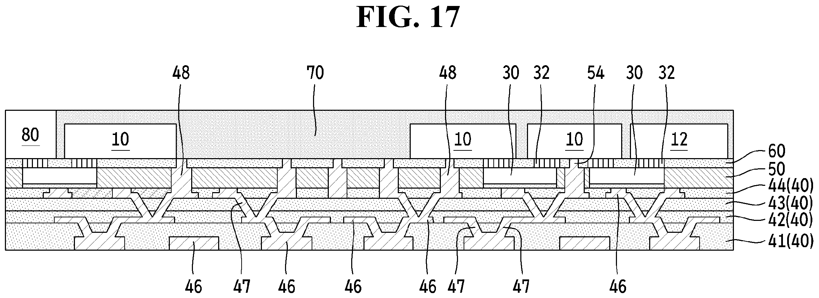

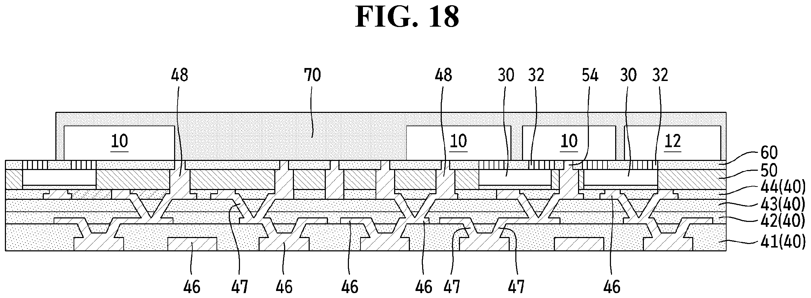

With reference to FIGS. 17-18, the operation 245 may include exposing and removing the sacrificial die 80. For example, with reference to FIG. 17, the exposing may include grinding away an upper surface of the second mold layer 70 such as to expose an upper surface of the sacrificial die 80 from the second mold layer 70. According to some example embodiments, a portion of the sacrificial die 80 may also be grinded away during such process, or an entirety of the sacrificial die 80 may remain after the grinding. With reference to FIG. 18, the removing the sacrificial die 80 may include etching the exposed sacrificial die 80. For example, the etching may include wet etching using, for example, potassium hydroxide (KOH).

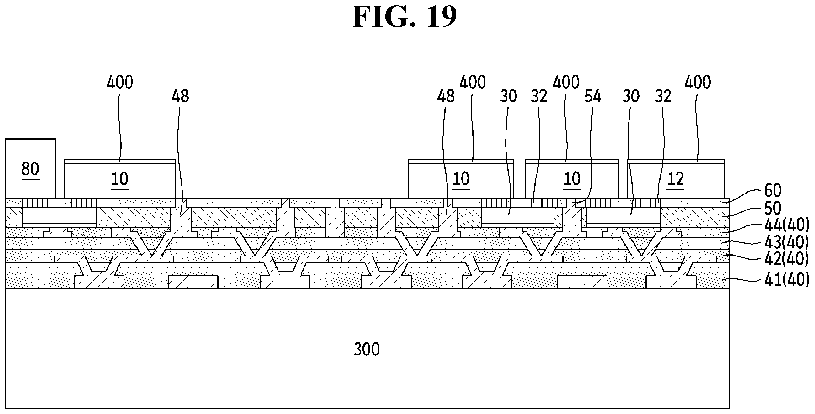

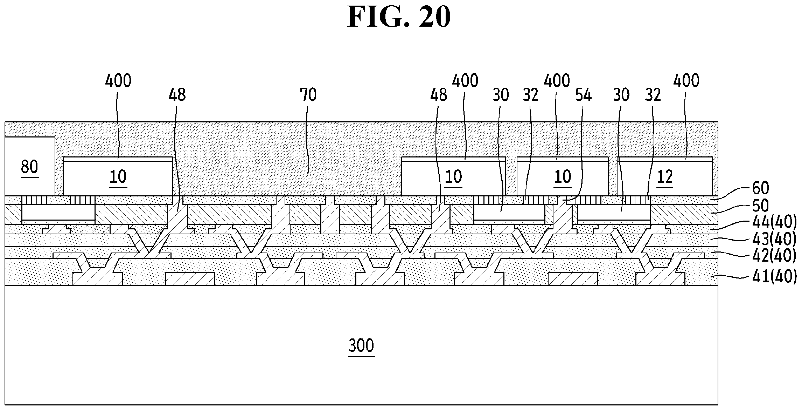

According to some embodiments, with reference to FIG. 19, a dielectric layer 400 may be provided (e.g., deposited) on the upper surfaces of the first semiconductor chips 10 and the second semiconductor chips 12. The dielectric layer 400 may be configured to protect the first semiconductor chips 10 and the second semiconductor chips 12 during an etching process (e.g., wet etching process), such as described above with respect to the operation 245. For example, FIGS. 20-23 illustrate an embodiment that includes the dielectric layer 400 while undergoing the operation 235, the operation 240, and the operation 245.

According to some example embodiments, the operations 205-245 may be performed with respect to any number of intermediate packages 2'. Accordingly, any number of intermediate packages 2' (which may also be referred to as sub-packages 2) that have undergone operations 205-245 may be subsequently reconstituted into the semiconductor package 1 as described above with respect to the operation 130 of FIG. 8A.

According to some example embodiments, the intermediate packages 2' may be singulated from before or after various operations of the method 200 of FIG. 8B. For example, the intermediate packages 2' may be singulated before any one from among the operations 210-250, and the remaining operations of the method 200 may be performed after the singulation. In other words, the operation 120 of the method 100 may performed before any one or more from among the operations 210-250, and the remaining operations of the method 200 may be performed after the singulation.

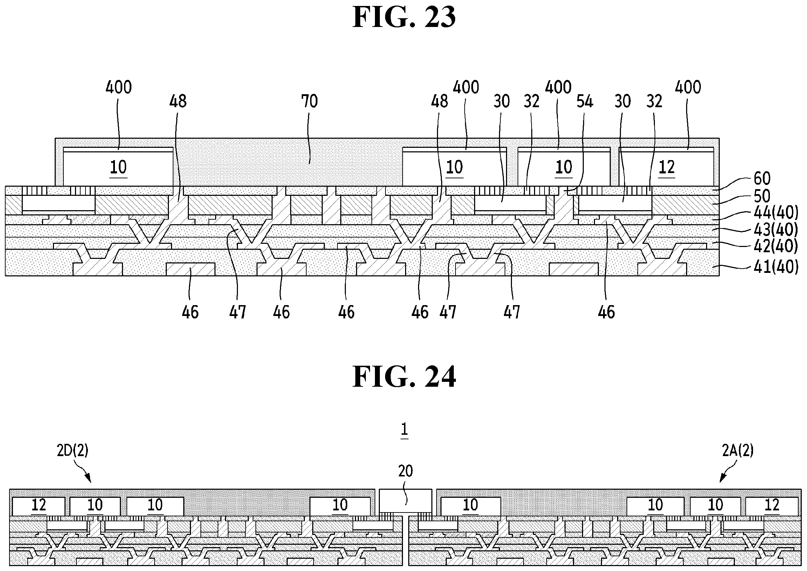

With reference to FIG. 24, the operation 250 may include connecting any number of the sub-packages 2 by connecting second bridges 20. For example, the sub-packages 2 may be arranged in a panel layout (e.g., refer to the example layouts of sub-packages 2 as shown in FIGS. 2-3), and the second bridges 20 may be mounted on pairs of the sub-packages 2 that are arranged adjacent to each other, such as to each overlap a pair of the sub-packages 2. For example, with reference to FIG. 7, the second bridges 20 may have second pads 32 (or bumps) on a bottom surface thereof that is electrically connected to respective pairs of the first bridges 30 via the second pads 32 (or bumps). For example, the second bridges 20 may be connected to respective pairs of the first bridges 30 via a thermocompression bonding (TCB) process or another mounting process.

With reference to FIG. 25, the operation 255 may include forming the molding material 90, which may be referred to as a panel-level mold. For example, with reference to FIG. 7, the molding material 90 may be formed such as to include the first portion 92, the second portion 94, and the third portion 96.

With reference to FIG. 26, the operation 260 may include exposing the first semiconductor chips 10 and the second semiconductor chips 12. For example, the exposing may include grinding away an upper surface of the second mold layer 70 and an upper surface of the molding material 90 (e.g., an upper surface of the first portion 92 and the third portion 96) such as to expose upper surfaces of the first semiconductor chips 10 and the second semiconductor chips 12 from the second mold layer 70. By performing the grinding process, the upper surfaces of the second mold layer 70, the molding material 90, the first semiconductor chips 10, and the second semiconductor chips 12 may become coplanar with each other.

According to the above, the semiconductor package 1 according to some example embodiments of the present disclosure may be manufactured.

According to some example embodiments, the semiconductor package 1 may be a semiconductor interposer.

According to some example embodiments, the sub-packages 2 may each be a semiconductor interposer-let (also referred to as a "semiconductor sub-interposer").

According to some example embodiments, a hybrid reconstituted panel level package (e.g., the semiconductor package 1) may be provided with an additional substrate underneath thereof, and/or the hybrid reconstituted panel level package may be configured to integrate directly with other components (e.g., a printed circuit board (PCB) and/or power delivery units).

According to some example embodiments, an FOPLP (e.g., the semiconductor package 1) may be provided in a large form factor such as, for example, larger than a standard 12 in. wafer (300 mm in diameter).

While non-limiting example embodiments have been described above in connection with the drawings, it will be apparent to those skilled in the art that modifications and variations could be made without departing from the scope of the present disclosure.

## Claims

1. A method of manufacturing a semiconductor device, the method comprising:
forming semiconductor sub-packages by performing a fan-out wafer level packaging process;
singulating the semiconductor sub-packages from at least one wafer; and
reconstituting the semiconductor sub-packages into a fan-out panel level package, FOPLP.

2. The method of claim 1, wherein the forming the semiconductor sub-packages comprises:
forming a first sub-package from among the semiconductor sub-packages by:
forming redistribution layers of the first sub-package;
providing a first bridge on the redistribution layers of the first sub-package; and
providing a semiconductor chip above the first bridge of the first sub-package, the semiconductor chip of the first sub-package electrically connected to the first bridge of the first sub-package; and
forming a second sub-package from among the semiconductor sub-packages by:
forming redistribution layers of the second sub-package;
providing a first bridge on the redistribution layers of the second sub-package; and
providing a semiconductor chip above the first bridge of the second sub-package, the semiconductor chip of the second sub-package electrically connected to the first bridge of the second sub-package.

3. The method of claim 1, wherein the reconstituting the semiconductor sub-packages into the FOPLP comprises:
arranging a first sub-package, from among the semiconductor sub-packages, and a second sub-package, from among the semiconductor sub-packages, adjacent to each other; and
providing a second bridge that electrically connects a first bridge of the first sub-package to a first bridge of the second sub-package.

4. The method of claim 3, wherein the second bridge is on the first sub-package and the second sub-package.

5. The method of claim 4, wherein the reconstituting the semiconductor sub-packages into the FOPLP further comprises forming a molding material that is between the first sub-package and the second sub-package and at least partially surrounds the second bridge.

6. The method of any one of claims 3 to 5, wherein a number of redistribution layers of at least one from among the first sub-package and the second sub-package is four or more.

7. The method of any one of claims 3 to 5, wherein a number of redistribution layers of each of the first sub-package and the second sub-package is four or more.

8. The method of any one of claims 3 to 7, wherein redistribution layers of at least one from among the first sub-package and the second sub-package has a line and space, L/S, of equal to or less than 2 µm.

9. The method of claim 2, wherein the reconstituting the semiconductor sub-packages into the FOPLP comprises:
arranging the first sub-package and the second sub-package adjacent to each other; and
providing a second bridge that electrically connects the first bridge of the first sub-package to the first bridge of the second sub-package.

10. The method of claim 9, wherein the second bridge is on the first sub-package and the second sub-package.

11. A fan-out panel level package, FOPLP, comprising:
semiconductor sub-packages that are fan-out wafer level packages, FOWLPs, the semiconductor sub-packages comprising:
a first sub-package comprising:
redistribution layers;
a first bridge on the redistribution layers of the first sub-package; and
a semiconductor chip above the first bridge of the first sub-package, the semiconductor chip of the first sub-package electrically connected to the first bridge of the first sub-package; and
a second sub-package comprising:
redistribution layers;
a first bridge on the redistribution layers of the second sub-package; and
a semiconductor chip above the first bridge of the second sub-package, the semiconductor chip of the second sub-package electrically connected to the first bridge of the second sub-package,
wherein, in the FOPLP, the semiconductor sub-packages are arranged adjacent to each other in at least one horizontal direction of the FOPLP.

12. The FOPLP of claim 11, further comprising a second bridge that electrically connects the first bridge of the first sub-package to the first bridge of the second sub-package.

13. The FOPLP of claim 12, wherein the second bridge is on the first sub-package and the second sub-package.

14. The FOPLP of claim 13, further comprising a molding material that is between the first sub-package and the second sub-package and at least partially surrounds the second bridge.

15. A fan-out panel level package, FOPLP, comprising:
semiconductor sub-packages comprising
a first sub-package comprising:
redistribution layers;
a first mold layer on the redistribution layers;
first semiconductor chips on the first mold layer; and
a second semiconductor chip, different from the first semiconductor chips, on the first mold layer; and
a second sub-package,
wherein the first mold layer comprises:
a first bridge that electrically connects one of the first semiconductor chips to a semiconductor chip of the second sub-package,
wherein, in the FOPLP, the semiconductor sub-packages are arranged adjacent to each other in at least one horizontal direction of the FOPLP.
